## Europäisches Patentamt
## European Patent Office
## Office européen des brevets

(19)

(11) Publication number: **0 250 259 B1**

(12) **EUROPEAN PATENT SPECIFICATION**

(45) Date of publication of the patent specification:
**19.09.90**

(51) Int. Cl.⁵: **C03C 13/00**
**// H05K1/03**

(21) Application number: **87305463.9**

(22) Date of filing: **19.06.87**

(54) Low dielectric fiber glass composition having improved water resistance and heat resistance.

(30) Priority: **20.06.86 JP 145457/86**

(43) Date of publication of application:
**23.12.87 Bulletin 87/52**

(45) Publication of the grant of the patent:
**19.09.90 Bulletin 90/38**

(84) Designated Contracting States:
**DE FR GB**

(56) References cited:
**EP-A- 0 124 800**
**DE-B- 1 072 367**

(73) Proprietor: **NIPPON ELECTRIC GLASS COMPANY, LIMITED, 7-1 Seiran 2-chome, Otsu-shi Shiga-ken(JP)**

(72) Inventor: **Imai, Katsuhiko, 17-13, Tsurunosato, Otsu-shi Shiga-ken(JP)**

(74) Representative: **Ritter, Stephen David et al, Mathys & Squire 10 Fleet Street, London EC4Y 1AY(GB)**

## Description

### Background of the Invention

#### 1) Field of the invention

The present invention relates to fiber glass composition and, in particular, to a glass composition for glass fibers adaptable for use in reinforcement of printed wiring boards.

#### 2) Description of the Prior Art

Among various types of the glass fiber, a so called "E" glass fiber has been used in electrical or electronic technical field, for example, for printed wiring boards, because of its unique electrical insulation properties, as disclosed by G. N. Bolen in the MANUFACTURE OF GLASS-FIBER YARNS FOR PRINTED WIRING BOARDS, 29th National SAMPE Symposium, April 3-5, 1984.

A kind of the E fiber glass is disclosed in U.S. Patent No. 2,334,961 by Schoenlaub, which consists, by weight, of $SiO_2$ 52-56 %, $Al_2O_3$ 12-16 %, $CaO$ 16-19 %, $MgO$ 3-6 %, and $B_2O_3$ 9-11 %.

U.S. Patent No. 2,571,074 by Tiede et al discloses another kind of the E glass which consists, by weight, of $SiO_2$ 52-56 %, $Al_2O_3$ 12-16 %, $CaO$ 19-25 %, and $B_2O_3$ 8-13 %.

However, a printed wiring board using the E glass fiber has been improper for use in high speed digital signal processing devices because it has a high dielectric constant (about 5.5) which causes unignorable time of signal propagation.

As another type of glass fiber having an improved dielectric constant, a so called "D" glass fiber is disclosed in "Handbook of Fillers and Reinforcements for Plastics", published by VAN NOSTRAND REINHOLD COMPANY, p.p. 480 and 481, and consists, by weight, of $SiO_2$ 74.5 %, $Al_2O_3$ 0.3 %, $B_2O_3$ 22.0 %, $CaO$ 0.5 %, $Li_2O$ 0.5 %, $Na_2O$ 1.0 %, and $K_2O$ 1.5 %. The D glass fiber has a dielectric constant of 3.56 for $10^6$ Hz, at 22 °C (72 °F).

Although the D glass fiber is desired in the dielectric constant, it has a problem in the water proof or water resistance. That is, the D glass is low in the water resistance and alkaline elements are eluted into water. Accordingly, the D glass fiber is low adhesive to plastic resin so that a printed wiring board using the D glass is degraded in reliability.

Further, the D glass fiber has a low strain point of about 470 °C and is, therefore, bad in the heat resistance. The glass fiber is heat-treated at 380 °C for 72 hours to fire the binder adhered to the fiber prior to application into the printed wiring board. At that time, the D glass fiber is apt to be deteriorated because of its low strain point.

### Summary of the Invention

Therefore, it is an object of the present invention to provide a fiber glass composition which has an improved water-resistance, alkali elution, and strain point, with a dielectric constant nearly equal to the conventional D glass fiber.

According to the present invention, a fiber glass composition is obtained which has dielectric constant of 4.5 or less for 1 MHz at the room temperature, a strain point of 485 °C or more, and improved water resistance, and which consists essentially, by weight, of $SiO_2$ 70-80 %, $Al_2O_3$ 0-2.0 %, $B_2O_3$ 15.0-21.5 %, $MgO$ 0-1.0 %, $CaO$ 0-2.0 %, $Li_2O$ 0-2.0%, $Na_2O$ 0-3.0 %, and $K_2O$ 0-3.0 %, $Li_2O + Na_2O + K_2O = 2.0$-5.0 %.

A preferable glass composition consists essentially, by weight, of $SiO_2$ 73.0-78.0 %, $Al_2O_3$ 0-1.0 %, $B_2O_3$ 18.0-21.0 %, $MgO$ 0-0.5 %, $CaO$ 0-1.0 %, $Li_2O$ 0-1.0%, $Na_2O$ 0-2.0 %, and $K_2O$ 0-2.0 %, $Li_2O + Na_2O + K_2O = 2.5$-4.5 %.

The manufacture of glass fiber products according to the glass composition of the present invention can be carried out according to a conventional producing method in the prior art, for example, as disclosed in the above-described MANUFACTURE OF GLASS FIBER YARNS FOR PRINTED WIRING BOARDS, p.p. 1361-1362.

The glass composition of the present invention contains $SiO_2$ 70.0-80.0 % by weight. Use of $SiO_2$ more than 80.0 % increases viscosity at an elevated temperature so that the glass is difficult to be melted. When $SiO_2$ amount is lower than 70.0 %, water resistance of the glass is low.

$Al_2O_3$ is an element for suppressing phase separation of the glass and for improving the water resistance. Use of $Al_2O_3$ more than 2.0 % undesirably raises the dielectric constant.

$B_2O_3$ is an element for reducing the viscosity of the glass and for making it easy to melt the glass. When the amount is lower than 15.0 %, the effect of $B_2O_3$ is not obtained. Upon $B_2O_3$ exceeding 21.5 %, the water resistance and the strain point are lowered.

The present invention attempts to use a reduced amount of $B_2O_3$ in comparison with the known D glass to thereby obtain the improved water resistance and the heat resistance.

MgO and CaO are included as elements for elevating the strain point of the glass. Inclusion of MgO more than 1 % and CaO more than 2 % undesirably results in an increased dielectric constant.

$Li_2O$ is also an element for reducing the viscosity of the glass, for making it easy to melt the glass, and for elevating the strain point. Use of $Li_2O$ more than 2 % makes the dielectric constant undesirably high. Further, it is uneconomical to include a large amount of $Li_2O$ because it is expensive.

$Na_2O$ and $K_2O$ are also for making it easy to melt the glass. Inclusion of each of them more than 3 % degrades the water resistance of the glass.

When the total amount of $Li_2O$, $Na_2O$, and $K_2O$ is less than 2 %, the resultant glass has a high viscosity at an elevated temperature and is difficult to be melted. When the total amount is more 5 %, the dielectric constant is more than 4.5 which is undesirable.

The fiber glass of the present invention can include a refining element or elements such as $As_2O_3$, $Sb_2O_3$, NaCl, $Na_2SO_4$, $CaF_2$, and other fluorides, or impurity or impurities such as $Fe_2O_3$ and $TiO_2$, if the included amount is 2 % or less by weight.

Examples

Examples of the present invention will be described below in comparison with a known D glass sample. Each sample glass fiber of Nos. 1-11 in Tables 1 and 2 was produced in the following manner.

## Table 1

| Sample No. | 1 | 2 | 3 | 4 | 5 | 6 |
|---|---|---|---|---|---|---|
| $SiO_2$ (wt%) | 74.6 | 75.1 | 76.4 | 75.3 | 75.0 | 74.8 |
| $Al_2O_3$ (wt%) | 1.0 | – | 1.0 | – | 0.8 | – |
| $B_2O_3$ (wt%) | 20.0 | 21.0 | 18.4 | 20.5 | 20.8 | 20.5 |
| MgO (wt%) | 0.5 | 0.3 | 0.2 | 0.4 | 0.1 | – |
| CaO (wt%) | 0.4 | 1.0 | 0.8 | 0.6 | – | 1.0 |
| $Li_2O$ (wt%) | 0.5 | 0.4 | 0.6 | 0.6 | 0.8 | 0.6 |
| $Na_2O$ (wt%) | 2.0 | 0.9 | 1.1 | 1.1 | 0.5 | 1.3 |
| $K_2O$ (wt%) | 1.0 | 1.3 | 1.5 | 1.5 | 2.0 | 1.8 |
| Dielectric constant (1 MHz) | 4.4 | 4.1 | 4.4 | 4.3 | 4.2 | 4.4 |
| Eluted alkali amount $R_2O$ (R=Li,Na,K) mg | 0.15 | 0.28 | 0.25 | 0.30 | 0.20 | 0.1 |
| Strain point ($^{o}C$) | 505 | 495 | 515 | 500 | 502 | 505 |

## Table 2

| Sample No. | 7 | 8 | 9 | 10 | 11 |
|---|---|---|---|---|---|
| $SiO_2$ (wt%) | 75.9 | 77.8 | 76.1 | 77.2 | 74.2 |
| $Al_2O_3$ (wt%) | 0.4 | 0.2 | 0.6 | 0.1 | 0.3 |
| $B_2O_3$ (wt%) | 19.3 | 18.8 | 20.8 | 19.8 | 22.0 |
| MgO (wt%) | 0.5 | 0.4 | - | 0.2 | - |
| CaO (wt%) | - | 0.3 | - | 0.2 | 0.5 |
| $Li_2O$ (wt%) | 0.4 | 0.2 | 0.9 | 1.0 | 0.5 |
| $Na_2O$ (wt%) | 2.0 | 2.0 | 0.8 | 0.8 | 1.0 |
| $K_2O$ (wt%) | 1.5 | 0.3 | 0.8 | 0.7 | 1.5 |
| Dielectric constant (1 MHz) | 4.5 | 4.1 | 4.1 | 4.1 | 4.1 |
| Eluted alkali amount $R_2O$ (R=Li,Na,K) mg | 0.23 | 0.19 | 0.17 | 0.20 | 0.45 |
| Strain point (°C) | 510 | 495 | 505 | 520 | 473 |

The batch was weighed in the amounts as shown in each Tables 1 and 2 and mixed as powders. The mixture was melted in a platinum crucible at about 1,550 °C for about 16 hours.

A part of the molten glass was flowed on a graphite plate to form a glass plate. The glass plate was annealed in a furnace and both surfaces of the glass plate was then polished. Thus, a test piece having a dimension of 50mm × 50mm × 3mm was obtained. The test piece was subjected to measurement of dielectric constant for 1 MHz at the room temperature.

The remaining part of the molten glass was used for measuring the alkali elution and the strain point.

The molten glass was crushed into powder by putting it into water, and the glass powder was subjected to an alkali elution test determined in the JIS (Japanese Industrial Standard) R 3502-1958 (reaffirmed: 1983).

EP 0 250 259 B1

The measurement of the strain point was carried out according to the ASTM C 336-71.

The measured dielectric constant, eluted alkali amount, and strain point of each sample glass Nos. 1-11 are shown in Table 1 and 2.

As shown in Tables 1 and 2, the glass samples Nos. 1-10 according to the present invention is nearly equal to the known D glass sample No. 11 in the dielectric constant. However, the eluted alkali amount is 0.15-0.30 mg for samples Nos. 1-10 according to the present invention but 0.45 for the known D glass sample No. 11. Therefore, the glass fiber according to the present invention is superior to the known D glass fiber in the water resistance. Further, the strain point (about 495-520 °C) of each sample Nos. 1-10 according to the present invention is higher than that (473 °C) of the known D glass sample No. 11. That is, the glass fiber according to the present invention also has an improved heat resistance.

**Claims**

1. A fiber glass composition having dielectric constant of 4.5 or less for 1 MHz at the room temperature and a strain point of 485 °C or more,and consisting essentially of, by weight, $SiO_2$ 70-80 %, $Al_2O_3$ 0-2.0 %, $B_2O_3$ 15.0-21.5 %, MgO 0-1.0 %, CaO 0-2.0 %, $Li_2O$ 0-2.0 %, $Na_2O$ 0-3.0 %, and $K_2O$ 0-3.0 %, $Li_2O + Na_2O + K_2O$ = 2.0-5.0 %.

2. A fiber glass composition as claimed in Claim 1, wherein said glass composition consists essentially of, by weight, $SiO_2$ 73.0-78.0 %, $Al_2O_3$ 0-1.0 %, $B_2O_3$ 18.0-21.0 %, MgO 0-0.5 %, CaO 0-1.0 %, $Li_2O$ 0-1.0%, $Na_2O$ 0-2.0 %, and $K_2O$ 0-2.0 %, $Li_2O + Na_2O + K_2O$ = 2.5-4.5 %.

**Patentansprüche**

1. Glasfaser-Zusammensetzung mit einer Dielektrizitätskonstanten von 4,5 oder weniger bei 1 MHz und Zimmertemperatur, ferner mit einem Belastungspunkt von 485°C oder mehr, im wesentlichen bestehend aus 70 bis 80 Gew.-% $SiO_2$, 0 bis 2,0 Gew.-% $Al_2O_3$, 15,0 bis 21,5 Gew.-% $B_2O_3$, 0 bis 1,0 Gew.-% MgO, 0 bis 2,0 Gew.-% CaO, 0 bis 2,0 Gew.-% $Li_2$, 0 bis 3,0 Gew.-% $Na_2O$ und 0 bis 3,0 Gew.-% $K_2O$, wobei $Li_2O + Na_2O + K_2O$ = 2,0 bis 5,0 Gew.-%.

2. Glasfaser-Zusammensetzung nach Anspruch 1, bestehend im wesentlichen aus 73,0 bis 78,0 Gew.-% $SiO_2$, 0 bis 1,0 Gew.-% $Al_2O_3$, 18 bis 21,0 Gew.-% $B_2O_3$, 0 bis 0,5 Gew.-% MgO, 0 bis 1,0 Gew.-% CaO, 0 bis 1,0 Gew.-% $Li_2O$, 0 bis 2,0 Gew.-% $Na_2O$ und 0 bis 2,0 Gew.-% $K_2O$, wobei $Li_2O + Na_2O + K_2O$ = 2,5–4,5 Gew.-%.

**Revendications**

1. Composition de fibre de verre présentant une constante diélectrique de 4,5 ou moins pour une fréquence de 1 MHz à la température ambiante, et un point de déformation de 485°C ou plus, cette composition étant constituée essentiellement, en poids, de 70 à 80% de $SiO_2$, de 0 à 2,0% d'$Al_2O_3$, de 15,0 à 21,5% de $B_2O_3$, de 0 à 1,0% de MgO, de 0 à 2,0% de CaO, de 0 à 2,0% de $Li_2O$, de 0 à 3,0% de $Na_2O$, et de 0 à 3,0% de $K_2O$, avec $Li_2O + Na_2O + K_2O$ = 2,0 à 5,0%.

2. Composition de fibre de verre selon la revendication 1, caractérisé en ce que cette composition est constituée essentiellement, en poids, de 73,0 à 78,0% de $SiO_2$, de 0 à 1,0% d'$Al_2O_3$, de 18,0 à 21,0% de $B_2O_3$, de 0 à 0,5% de MgO, de 0 à 1,0% de CaO, de 0 à 1,0% de $Li_2O$, de 0 à 2,0% de $Na_2O$, et de 0 à 2,0% de $K_2O$, avec $Li_2O + Na_2O + K_2O$ = 2,5 à 4,5%.

6